# EUROPÄISCHE PATENTANMELDUNG

(11) **EP 1 067 680 A2**
(43) Veröffentlichungstag der Anmeldung: **10.01.2001**
(21) Anmeldenummer: 00112921.2
(22) Anmeldetag: 20.06.2000
(51) Int. Cl.: H03G 3/30

(54) **Automobiles Soundsystem und Automobil mit einem solchen**

(30) Priorität: 07.07.1999 DE 19931270
(71) Anmelder: Harman Audio Electronic Systems GmbH, 94315 Straubing (DE)
(72) Erfinder: Scholz, Leander, 94330 Salching (DE); Puls, Bernhard, 94360 Mitterfels (DE)
(74) Vertreter: Westphal, Mussgnug & Partner, Patentanwälte

(57) **Zusammenfassung**

Die Erfindung betrifft ein automobiles Soundsystem mit einer Audiosignalquelle 3, insbesondere einem CD-Wechsler, mit mehreren Lautsprechern 4A, 4B und mit einem Verstärker 2 für die Verstärkung der von der Audiosignalquelle 3 zugeführten Audiosignale und für die Zuführung der verstärkten Audiosignale zu den einzelnen Lautsprechern 4A, 4B. Der Verstärker 2 zeigt eine Zuleitung für ein Geschwindigkeitssignal, anhand welchem die Verstärkung der Audiosignale die lautsprecherspezifisch, abhängig von deren Lage im Fahrgastraum, gewählst ist. Es hat sich bewährt, mit zunehmender Geschwindigkeit die Verstärkung der Audiosignale für die Lautsprecher im Fondbereich des Fahrgastraums relativ zu der Verstärkung der Audiosignale für die Lautsprecher im Frontbereich des Fahrgastraums höher zu wählen. Durch diese Ausbildung der Steuerung des automobilen Soundsystems wird ein besonders angenehmens Klangbild mit einer sehr vorteilhaften räumlichen Auflösbarkeit des Audiosignals erreicht.

## Beschreibung

Die Erfindung betrifft ein automobiles Soundsystem sowie ein Automobil mit einem solchen. Es sind automobile Soundsysteme bekannt, die eine Audiosignalquelle, beispielsweise einen Rundfunkempfänger, und mehrere Lautsprecher sowie einen Verstärker für die Verstärkung der von der Audiosignalquelle zugeführten Audiosignale und für die Zuführung der verstärkten Audiosignale zu den einzelnen Lautsprechern aufweisen. Dabei ist der Verstärker so gesteuert, daß mit zunehmender Fahrzeuggeschwindigkeit die Lautstärke des durch die Lautsprecher wiedergegebenen Audiosignals respektive der Verstärkungsfaktor des Verstärkers erhöht wird. Das Geschwindigkeitssignal erhält der Verstärker über eine Zuleitung vom Tachosignal des Automobils. Durch die geschwindigkeitsabhängige Anhebung der Lautstärke respektive der Verstärkung des Verstärkers wird ein Ausgleich für die mit zunehmender Geschwindigkeit anwachsenden Fahrtgeräusche, vorzugsweise die zunehmenden Rollgeräusche und zunehmenden Windgeräusche, geschaffen. Hierdurch wird sichergestellt, daß die Fahrzeuginsassen auch bei höherer Geschwindigkeit das Audiosignal immer noch wahrnehmen können. Damit ist ein völliges Verdecken des Audiosignals durch die Fahrtgeräusche bei höheren Geschwindigkeiten ausgeschlossen. Dennoch erweist sich das wiedergegebene Audiosignal als von recht schlechter Qualität insbesondere hinsichtlich dessen räumlicher Auflösung was insbesondere mit zunehmender Geschwindigkeit verstärkt auftritt.

Der Erfindung liegt die Aufgabe zugrunde, ein automobiles Soundsystem sowie ein Automobil mit einem Soundsystem zu schaffen, welches ein verbessertes räumlich aufgelöstes Audiosignal wiedergibt.

Diese Aufgabe wird erfindungsgemäß durch ein automobiles Soundsystem mit den Merkmalen des Anspruchs 1 sowie ein Automobil mit den Merkmalen des Anspruchs 10 gelöst.

Vorteilhafte Weiterbildungen ergeben sich aus den Unteransprüchen.

Das erfindungsgemäße automobile Soundsystem ist so ausgebildet, daß es die unterschiedlichen Lautsprecher geschwindigkeitsabhängig mit unterschiedlich stark verstärkten Audiosignalen beaufschlagt. Dadurch wird insbesondere ermöglicht, daß die Lautsprecher in Fond des Kraftfahrzeuges im Gegensatz zu den Lautsprechern im Frontbereich des Fahrzeugs mit zunehmender Geschwindigkeit stärker verstärkte Audiosignale zugeführt werden, wodurch im Fondbereich mit zunehmender Geschwindigkeit ein lautstärkemässig deutlich überhöhtes Audiosignal relativ zu dem Audiosignal im Frontbereich des Fahrzeuginnenraums wiedergegeben wird. Durch diese spezifische Steuerung der Verstärkungsfaktoren der einzelnen Lautsprecherkanäle des Verstärkers wird ermöglicht, daß die durch die Fahrgeräusche verändernde akustische Umgebung nicht zu einer Zerstörung der räumlichen Auflösbarkeit des Audiosignals führt. Ursächlich hierfür ist insbesondere die mit zunehmender Geschwindigkeit stärkere Verstärkung der im Fondbereich wiedergegebenen Audiosignale. Dies kann einerseits dadurch erreicht werden, daß die Verstärkungsfaktoren der Audiokanäle für die Lautsprecher im Fondbereich dementsprechend mit zunehmender Geschwindigkeit erhöht werden oder dadurch, daß die Verstärkungsfaktoren der Audiokanäle der Lautsprecher im Frontbereich relativ zu den Verstärkungsfaktoren für den Fondbereich abgesenkt werden. Wird das erfindungsgemäße automobile Soundsystem in einem Cabrio angeordnet, so kommt dessen besonders vorteilhafte akustische Wirkung zur Erhaltung der räumlichen Auflösbarkeit der Audiosignale, also des Stereophoneffekts in besonderem Maße zum Tragen, denn gerade diese Fahrzeuge neigen dazu, mit zunehmender Geschwindigkeit aufgrund der Windgeräusche an Klangqualität und insbesondere an räumlicher Auflösung zu verlieren.

Nach einer bevorzugten Ausführungsform des automobilen Soundsystems ist der Steuerung ein Speicher zugeordnet, der eine Tabelle aufweist, die eine Zuordnung von Geschwindigkeitswerten zu lautsprecherspezifischen Verstärkungsfaktoren zeigt. Anhand dieser Tabelle wird der Verstärker durch die Steuerung so angesteuert, daß die Verstärkung der Audiosignale der Audiosignalkanäle der einzelnen Lautsprecher auf Basis des zugeführten Geschwindigkeitswertes festgelegt wird. Diese Tabelle beinhaltet die geschwindigkeitsabhängig differenzierten Verstärkungsfaktoren für die einzelnen Lautsprecher, wobei die Lautsprecher im Fondbereich entsprechend stärker verstärkte Audiosignale erhalten als die des Frontbereichs. Durch die Gewinnung der Verstärkungsfaktoren aus der Tabelle in den Speicher ist eine technisch sehr einfache und robuste Steuerung des Soundsystems möglich, die ohne kostenintensive Prozessorleistung auskommt. Dabei kann der Speicher sowohl von der Steuerung getrennt als auch als Teil dieser ausgebildet sein. Der Inhalt des Speichers läßt sich vorzugsweise durch äußere Programmierung verändern, wodurch eine Anpassung an andere Lautsprecher, andere Verstärkerstufen, andere Fahrzeuge, in denen das Soundsystem eingebaut wird, vorgenommen werden kann. Mithin ist ein sehr flexibles und den spezifischen Kundenwünschen und technischen Erfordernissen anpassbares automobiles Soundsystem gegeben, das auf einfache Weise und kostengünstige Weise den jeweiligen Bedürfnissen angepasst werden kann. Damit ist auch unter geänderten Bedingungen stets ein besonders angenehmens audiophones Klangbild auch unter unterschiedlichsten äußeren Verhältnissen, insbesondere bei unterschiedlichen Geschwindigkeiten des Fahrzeugs, gewährleistet.

Vorzugsweise ist das Soundsystem mit einer Eingabeeinheit versehen, die mit der Steuerung verbunden ist und mittels der die Zuordnung der lautsprecherspezifischen Verstärkungsfaktoren zu den Geschwindigkeitswerten festlegbar ist. Mittels der Eingabeeinheit können die in der Tabelle im Speicher abgelegten Geschwindigkeitswerte und die Verstärkungsfaktoren durch neue Werte oder Faktoren ersetzt oder ergänzt oder gestrichen werden. Eine Ergänzung ist dann erforderlich, wenn neue Lautsprecher und damit das Erfordernis für einen neuen Audiokanal hinzugekommen ist, während ein Entfernen dann relevant ist, wenn ein Audiokanal durch Entfernen eines Lautsprechers oder durch Ersetzen des Verstärkers durch einen mit weniger Audiokanälen erforderlich ist.

Weiterhin ist es möglich, daß durch die Eingabeeinheit Parameter für die Berechnung der einzelnen Verstärkungsfaktoren nach einer mathematischen Beziehung in Abhängigkeit der Geschwindigkeitswerte als eine weitere bevorzugte Ausbildungsform der Steuerung für ein erfindungsgemäßes Soundsystem eingegeben werden. Diese besondere Ausbildung des erfindungsgemäßen Soundsystems mit einer Festlegung der lautsprecherspezifischen Verstärkungsfaktoren anhand einer Rechenvorschrift in Abhängigkeit der zugeführten Geschwindigkeitswerte ermöglicht eine sehr einfache und sicher definierte Bestimmung der einzelnen lautsprecherspezifischen Verstärkungsfaktoren. Dabei kann auf einen Speicher mit einer sehr umfangreichen Tabelle mit einer Vielzahl von Verstärkungsfaktoren für jeden einzelnen Geschwindigkeitswert verzichtet werden, was für die Handhabung des Soundsystems insbesondere bei der Verwendung eines digital gesteuerten Verstärkes mittels eines DSP's von Vorteil ist. Diese DSP-Bausteine zeigen Rechenwerke zur Berechnung der einzelnen digitalen Soundsignale, wobei diese Rechenwerke nun erfindungsgemäß zur Berechnung der einzelnen lautsprecherspezifischen Verstärkungsfaktoren in Abhängigkeit der zugeführten Geschwindigkeitswerte anhand einer parameterabhängigen Rechenvorschrift verwendet werden. Insoweit ist kein zusätzliches Rechenwerk zur Berechnung der Verstärkungsfaktoren für das erfindunsgemäße Soundsystem erforderlich, was die Kosten, den Programmieraufwand und den Hardweareaufwand für ein derartiges Soundsystem wesentlich verringert.

Es hat sich besonders bewährt, die lautsprecherspezifischen Verstärkungsfaktoren für den Fondbereich überproportional zu den Geschwindigkeitswerten zu erhöhen, wodurch ein sehr angenehmens und räumlich aufgelöstes Klangbild des Soundsystems gegeben ist. Durch eine quadratische Beziehung ist eine besonders bewährte Erhöhung der Lautstärke im Fondbereich relativ zu der Erhöhung im Frontbereich abhängig von der Geschwindigkeit gegeben. Durch die Erfindung ist sichergestellt, daß das Fading zwischen dem Fondbereich und dem Frontbereich des Fahrgastraums des Automobils mit zunehmender Geschwindigkeit des Automobils sich in Richtung Fondbereich verändert, wodurch die Lautstärke der durch die Lautsprecher im Fondbereich wiedergegebenen Audiosignale relativ zu denen der Lautsprecher im Frontbereich erhöht sind.

Es hat sich besonders bewährt neben dieser erfindungsgemäßen, lautsprecherspezifischen, geschwindigkeitsabhängigen Verstärkung der einzelnen Audiosignale zusätzlich eine frequenzbereichsabhängige Festlegung der Verstärkungsfaktoren vorzusehen. Durch diese zusätzliche Abhängigkeit ist gewährleistet, daß die mit zunehmender Geschwindigkeit scheinbar verschwindenden Audiosignale im Baßbereich und/oder im Höhenbereich eine zusätzliche geschwindigkeitsabhängige Verstärkung erfahren. Somit ergibt sich für jeden Lautsprecher des Soundsystems im Automobil ein für diesen Audiokanal bestimmter Verstärkungsfaktor, der geschwindigkeitsabhängig ist und aus einem Anteil an Verstärkungsfaktor abhängig von der frequenzspezifischen Ausbildung des Audiosignals sowie einem weiteren Anteil am Verstärkungsfaktor, der sich nach der Lage des Lautsprechers in der Fahrgastzele (Fondbereich oder Frontbereich oder dazwischen) richtet. Durch diese Kombination ist ein besonders vorteilhaftes Klangbild im Automobil auch unter sehr schwierigen akustischen Verhältnissen eines Fahrgastraum, beispielsweise bei dem Fahrgastraum eines Cabrios, gegeben.

Nach einer bevorzugten Ausführungsform des erfindunsgemäßen Soundsystems ist die Steuerung so ausgebildet, daß die lautsprecherspezifischen und ggf. frequenzspezifischen Verstärkungsfaktoren in Abhängigkeit des Geschwindigkeitssignals einen Maximalwert, eine Obergrenze, nicht überschreiten so daß eine Zerstörung der Lautsprecher, der Verstärkerstufen oder einzelner Komponenten des Soundsystems verhindert ist. Im übrigen ist hierdurch sichergestellt, daß die verstärkten Audiosignale kein Clipping zeigen, welches durch übersteuerte Verstärkerstufen hervorgerufen wird.

Neben dem erfindunsgemäßen Soundsystem betrifft die Erfindung auch ein Automobil mit einem automobilen Soundsystem, welches über den Fahrgastraum verteilte Lautsprecher aufweist. Diese sind sowohl im Fond- als auch im Frontbereich des Fahrgastraums Lautsprecher angeordnet und werden durch entsprechende Audiokanäle des Verstärkers spezifisch mit verstärkten Audiosignalen versehen. Dabei ist der Verstärker so gesteuert, daß die einzelnen Verstärkerstufen in den einzelnen Audiokanälen geschwindigkeitsabhängig unterschiedliche Verstärkungsfaktoren für die Verstärkung der Audiosignale heranziehen. Dadurch ist gewährleistet, daß die Lautsprecher im Fondbereich mit zunehmender Geschwindigkeit stärker verstärkte Audiosignale erhalten, während die Lautsprecher im Frontbereich weniger stark verstärkte Audiosignale zugeführt bekommen. Dieser Unterschied der Verstärkungsfaktoren und damit der Lautstärke der Audiosignale der Fondbereichtslautsprecher gegenüber den Frontbereichslautsprechern wird mit zunehmender Geschwindigkeit immer größer werden.

Vorzugsweise ist die Zuleitung für das Geschwindigkeitssignal durch eine CAN-Bus, I²C-Bus- oder eine I-Bus-Leitung realisiert, über die zwischen den einzelnen Komponenten des Fahrzeuges relevante Fahrzeugdaten ausgetauscht werden. Beispielsweise werden über diese Fahrzeugbusleitung vom Tachosignalgeber das Geschwindigkeitssignal an die Busleitung gegeben und kann dann von allen Komponenten des Fahrzeugs, also auch von dem automobilen Soundsystem vom Bus über dessen Zuleitung zum automobilen Soundsystem abgegriffen werden und der Steuereinheit zur weiteren Verarbeitung zugeführt werden.

Ein bevorzugtes Ausführungsbeispiel der Erfindung ist in der Zeichnung dargestellt und wird im folgenden näher beschrieben.
- Fig. 1: zeigt den beispielhaften Aufbau eines erfindungsgemäßen Automobils und
- Fig. 2: zeigt einen beispielhaften Aufbau eines Verstärkers des beispielhaften Audiosoundsystems gemäß Fig. 1.

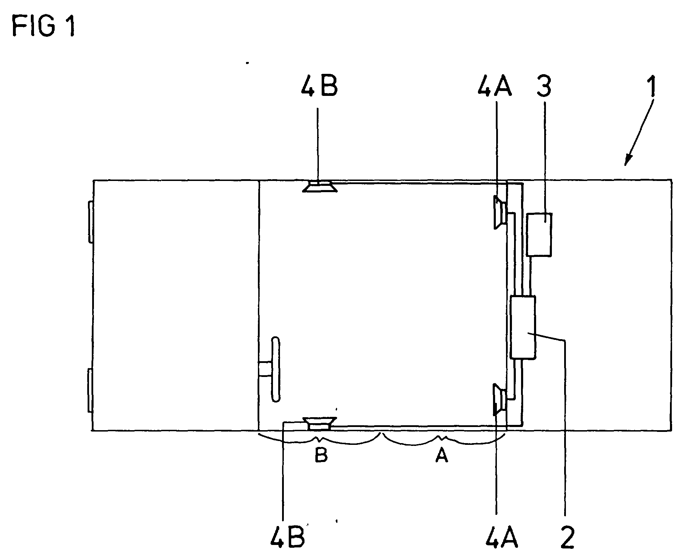

In Fig. 1 ist ein erfindungsgemäßes Automobil 1 dargestellt, dessen Fahrgastraum sich in den Fondbereich A und den Frontbereich B aufgliedert. Im Frontbereich B ist die Fahrerposition und die Beifahrerposition angeordnet. Das Automobil 1 ist mit einem automobilen Soundsystem ausgestattet, welches einen Vertärker 2, eine Datenquelle 3 in Form eines CD-Wechslers und vier Lautsprecher 4A, 4B zeigt. Die Lautsprecher 4A, 4B sind über den Fahrgastraum verteilt angeordnet, wobei zwei Lautsprecher 4A im Fondbereich A angeordnet sind, während die anderen beiden Lautsprecher 4B im Frontbereich B des Fahrgastraumes des Automobils 1 angeordnet sind. Der Verstärker 2 und der CD-Wechsler 3 sind hinter der Rückbank des Automobils außerhalb des Fahrgastraums angeordnet, wodurch der Verstärker 2 und der CD-Wechsler 3 sehr gut durch den geöffneten Kofferraum des Automobils 1 zugänglich sind.

Die von dem CD-Wechsler 2 generierten Audiosignale werden über eine Zuleitung zu dem Verstärker 2 zugeführt und durch den Verstärker 2 verstärkt, wobei das Audiosingal durch vier Verstärkerstufen 9, die jeweils einem Lautsprecher 4A, 4B zugeordnet sind, lautsprecherspezifisch verstärkt werden.

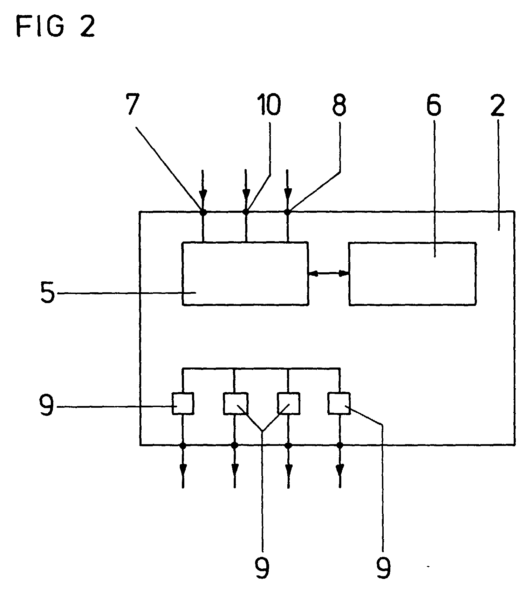

Aus Fig. 2 ist der prinzipielle Aufbau des Verstärkers 2 gemäß Fig. 1 dargestellt. Der Verstärker 2 zeigt drei Zuleitungen, eine Zuleitung 7 für das Geschwindigkeitssignal V des Automobils 1, eine Zuleitung 8 für das Ein- und Auslesen von Verstärkungsfaktoren oder Geschwindigkeitswerten und eine Zuleitung 10 für die Zuführung der Audiodaten von dem CD-Wechsler 3. Diese Zuleitungen 7, 8, 10 sind mit der Steuerung 5 des Verstärkers 2 verbunden, welche wiederum mit dem Speicher 6 des Verstärkers 2 und den vier Verstärkerstufen 9 des Verstärkers 2 verbunden ist. In der Steuerung 5 werden die über die Zuleitung 10 zugeführten Audiodaten des CD-Wechslers 3 aufbereitet und an die Verstärkerstufen 9 zur lautsprecherspezifischen Verstärkung weitergeleitet.

Neben einer Reihe spezifischer Audiosignalverarbeitungsfunktionalitäten zeigt die Steuerung 5 die Möglichkeit das Fadeing zwischen den Lautsprechern 4A im Fondbereich A zu den Lautsprechern 4B in Frontbereich B geschwindigkeitsabhängig zu verändern. Dabei wird anhand des über die Zuleitung 7 zugeführten Geschwindigkeitssignals V aus dem Speicher 6 die dem aktuellen Geschwindigkeitswert des Automobils 1 entsprechenden Verstärkungfaktoren für die Verstärkungsstufen 9 ausgelesen und über die Steuerung 5 den einzelnen Verstärkerstufen 9 zugeführt. Diese verstärken entsprechend den lautsprecherspezifisch ausgelesenen Verstärkungsfaktoren das ihnen zugeführte Audiosignal und leiten es an den dementsprechenden Lautsprecher 4A, 4B weiter. Dabei ist in dem Speicher 6 eine Tabelle abgelegt, die tabellarisch eine Zuordnung von Geschwindigkeitswerten zu den einzelnen Verstärkungsfaktoren für die einzelne Verstärkerstufen 9 dargestellt, welche fest mit einem Lautsprecher 4A, 4B verbunden sind, wobei diese an einer festgelegten Position des Fahrgastraumes angeordnet sind. Anhand dieser tabellarischen Zuordnung ist es möglich, die einzelnen Lautsprecher 4A, 4B positionsspezifisch abhänig von dem jeweiligen Geschwindigkeitssignal differenziert zueinander mit verschieden stark verstärkten Audiosignalen zu beaufschlagen.

Durch eine Festlegung der Verstärkungsfaktoren in Abhängigkeit von der Geschwindigkeit in der Art, daß mit zunehmender Geschwindigkeit die Verstärkungsfaktoren für die Lautsprecher 4A im Fondbereich A größer sind als diejenigen für die Lautsprecher 4B im Frontbereich B, ist es möglich, das Klangbild im Fahrgastraum sehr differenziert auszubilden und dabei die räumliche Auflösbarkeit des akustischen Audiosignals zu erhalten. Diese räumliche Auflösbarkeit wird dabei auch bei den unterschiedlichen Geschwindigkeiten in vorteilhafter Weise aufrecht erhalten.

Durch eine zusätzliche geschwindigkeitsabhängige Erhöhung der Verstärkungsfaktoren für Audiosignale im Bass- und auch im Höhenfrequenzbereich gelingt es, das angenehme, räumlich differenzierte Klangbild weiter zu verbessern und die störenden Fahrgeräusche, die geschwindigkeitsabhängig sind, in den Hintergrund treten zu lassen.

Über die Zuleitung 8 des Verstärkers 2, welcher mit einer Eingabeeinheit für die Steuerung des Soundsystems verbunden ist, ist es möglich, die einzelnen in der Tabelle im Speicher 6 abgelegten Werte, sei es Geschwindigkeitswerte oder auch Verstärkungsfaktoren, zu ändern, zu löschen oder zu ergänzen. Hierdurch ist es möglich, das automobile Soundsystem an geänderte äußere Bedingungen anzupassen. Diese geänderten Bedingungen können einerseits durch ein geändertes Hörempfinden des Benutzers oder durch geänderte technische Aspekte des Soundsystems bedingt sein. Beispielsweise könnten ein weiterer Lautsprecher dem Soundsystem zugeführt werden, der bestehenden Verstärkerkanal respektive einer bestehenden Verstärkerstufe 9 bzw. einer zusätzlichen Verstärkerstufe zugeordnet wird. Es ist erforderlich, daß der Tabelle geänderte oder ergänzte Verstärkungsfaktoren eingeschrieben werden und diese für die geschwindigkeitsabhängige Steuerung des automobilen Soundsystems verwendet werden. Wird das automobile Soundsystem aus einem Fahrzeug ausgebaut und in ein anderes Kraftfahrzeug von einem anderen Typ eingebaut, so hat dies Auswirkungen auf das optimierte Festlegen der lautsprecherspezifischen Verstärkungsfaktoren, die jeweils einen bestimmten Geschwindigkeitswert zugeordnet sind. Durch die Möglichkeit einer Eingabe von geänderten Geschwindigkeitswerten und/oder Verstärkungsfaktoren, ist es möglich, die Anpassung des automobilen Soundsystems ohne Hardwareänderung allein durch Veränderung der Steuerparameter vorzunehmen, was den universellen, kostengünstigen Einsatz des automobilen Soundsystems für eine Vielzahl von Automobilen deutlich macht.

### Bezugszeichenliste

- 1: Automobil
- 2: Verstärker
- 3: Audiodatenquelle, CD-Wechsler
- 4A, 4B: Lautsprecher
- 5: Steuerung
- 6: Speicher
- 7: Zuleitung des Geschwindigkeitssignals
- 8: Zuleitung für Parameter der Tabelle
- 9: Verstärkerstufen
- 10: Zuleitung des Audiosignals
- A: Fondbereich des Fahrgastraums
- B: Frontbereich des Fahrgastraums

## Patentansprüche

1. Automobiles Soundsystem mit einer Audiosignalquelle, mit mehreren Lautsprechern und mit einem Verstärker für die Verstärkung der von der Audiosignalquelle zugeführten Audiosignale und für die Zuführung der verstärkten Audiosignale zu den einzelnen Lautsprechern, wobei der Verstärker eine Zuführung für ein Geschwindigkeitssignal eines Automobils und eine Steuerung zeigt, **dadurch gekennzeichnet**, daß die Steuerung (5) so ausgebildet ist, daß durch sie unterschiedliche Lautsprecher (4A, 4B) geschwindigkeitsabhänig mit unterschiedlich stark verstärkten Audiosignalen beaufschlagt werden.

2. Automobiles Soundsystem nach Anspruch 1, **dadurch gekennzeichnet**, daß der Steuerung (5) ein Speicher (6) zugeordnet ist, der eine Tabelle aufweist, die eine Zuordnung von Geschwindigkeitswerten zu lautsprecherspezifischen Verstärkungsfaktoren zeigt, und daß die Steuerung so ausgebildet ist, daß diese lautsprecherspezifische Verstärkung der Audiosignale für die einzelnen Lautsprecher (4A, 4B) mittels der Tabelle geschwindigkeitsabhängig erfolgt.

3. Automobiles Soundsystem nach Anspruch 1, **dadurch gekennzeichnet**, daß die Steuerung (5) so ausgebildet ist, daß sie anhand einer Rechenvorschrift die lautsprecherspezifischen Verstärkungsfaktoren in Abhängigkeit der zugeführten Geschwindigkeitswerten berechnet und die Verstärkung der Audiosignale für die einzelnen Lautsprecher (4A, 4B) geschwindigkeitsabhängig erfolgt.

4. Automobiles Soundsystem nach einem der vorstehenden Ansprüche, **dadurch gekennzeichnet**, daß es eine Eingabeeinheit aufweist, die mit der Steuerung (5) verbunden ist und über die die Zuordnung der lautsprecherspezifischen Verstärkungsfaktoren zu den gewünschten Geschwindigkeitswerten bzw. Parameter für die Rechenvorschrift zur Bestimmung der lautsprecherspezifischen Verstärkungsfaktoren veränderbar sind.

5. Automobiles Soundsystem nach einem der vorstehenden Ansprüche, **dadurch gekennzeichnet**, daß die Steuerung (5) so ausgebildet ist, daß eine überproportionale Beziehung zwischen zumindest einem Teil der Verstärkungsfaktoren zu den zugeführten Geschwindigkeitswerten gegeben ist.

6. Automobiles Soundsystem nach einem der vorstehenden Ansprüche, **dadurch gekennzeichnet**, daß die Steuerung (5) so ausgebildet ist, daß die geschwindigkeitsabhängig gewählten lautsprecherspezifischen Verstärkungsfaktoren zusätzlich frequenzbereichsabhängig gewählt sind, wobei insbesondere der Baßbereich eine zusätzliche Erhöung des Verstärkungsfaktors erfährt.

7. Automobiles Soundsystem nach Anspruch 6, **dadurch gekennzeichnet**, daß die Steuerung (5) so ausgebildet ist, daß die frequenzbereichsabhängige Änderung der lautsprecherspezifischen Verstärkungsfaktoren geschwindigkeitsabhängig gewählt ist.

8. Automobiles Soundsystem nach Anspruch 7, **dadurch gekennzeichnet**, daß die Steuerung (5) so ausgebildet ist, daß die frequenzbereichsabhängige Änderung der lautsprecherspezifischen Verstärkungsfaktoren so gewählt ist, daß mit zunehmender Geschwindigkeit die Verstärkung im Baßbereich und/oder im Höhenbereich erhöht gewählt ist.

9. Automobiles Soundsystem nach einem der vorstehenden Ansprüche, **dadurch gekennzeichnet**, daß die Steuerung (5) so ausgebildet ist, daß die geschwindigkeitsabhängig gewählte lautsprecherspezifischen Verstärkungsfaktoren so gewählt sind, daß eine Obergrenze der Verstärkung der Audiosignale gegeben ist.

10. Automobil mit einem automobilen Soundsystem nach einem der vorstehenden Ansprüche, **dadurch gekennzeichnet**, daß die Lautsprecher (4A, 4B) über den Fahrgastraum mit Fondbereich (A) und Frontbereich (B) verteilt sind und daß die geschwindigkeitsabhängige Verstärkung der Audiosignale für die Lautsprecher (4A) im Fondbereich (4A) höher, insbesondere mit höherer Geschwindigkeit umso höher ist als die Verstärkung der Audiosignale für die Lautsprecher (4B) im Frontbereich (B).
